# EUROPEAN PATENT APPLICATION

(11) **EP 4 255 143 A1**
(43) Date of publication of application: **04.10.2023**
(21) Application number: 20963519.2
(22) Date of filing: 27.11.2020
(51) Int. Cl.: H05K 13/00

(54) **SUBSTRATE PRODUCTION SIMULATION METHOD**

(71) Applicant: Fuji Corporation, Chiryu-shi, Aichi 472-8686 (JP)
(72) Inventor: MORITA, Yukitoshi, Chiryu-shi, Aichi 472-8686 (JP)
(74) Representative: Grünecker Patent- und Rechtsanwälte PartG mbB
(86) International application number: PCT/JP2020/044163
(87) International publication number: WO 2022/113254

(57) **Abstract**

In a substrate production simulation method, production of a product substrate on which mounting of a component supplied from a component supply device is completed is simulated using a substrate production line including a mounting line in which multiple component mounters for mounting the component on a substrate are arranged. The method includes steps (a) to (c). In the step (a), a first result is obtained by simulation on the assumption that provision and collection of the component supply device with respect to the substrate production line are performed without delay. In the step (b), a second result is obtained by simulation on the assumption that provision and/or collection of the component supply device with respect to the substrate production line is performed by an automated facility and/or a worker. In the step (c), the first result and the second result are output to the same screen in a form indicating a transition of a production number of product substrates with respect to time.

## Description

### Technical Field

The present specification discloses a substrate production simulation method.

### Background Art

Conventionally, as a production simulation method, a method disclosed in Patent Literature 1 is known. In the method of Patent Literature 1, a computer simulates and calculates a layout of multiple processing devices in a production area, a movement of multiple conveyance means, and a load caused by an arrangement of personnel of an operator. In this simulation calculation, a load factor, throughput, a device operating ratio, and the like of the operator are calculated. According to this method, in the formulation of the layout, it is possible to design the layout in consideration of the number and arrangement of the operators.

### Patent Literature

Patent Literature 1: JP-A-2005-100092

### Summary of the Invention

### Technical Problem

However, in the method of Patent Literature 1, the load factor, the throughput, the device operating ratio, and the like of the operator are calculated, but delay in process by the operation of the operator cannot be grasped. Therefore, it is not possible to set the number of operators so that the delay in the process by the operation of the operator is canceled.

The present disclosure has been made to solve the above-described problems, and a main object thereof is to easily confirm the delay in the substrate production caused by an automated facility or workers in a substrate production simulation method.

### Solution to Problem

According to an aspect of the present disclosure, there is provided a substrate production simulation method of simulating production of a product substrate on which mounting of a component supplied from a component supply device is completed using a substrate production line including a mounting line in which multiple component mounters for mounting the component on a substrate are arranged along a conveyance direction of the substrate, the substrate production simulation method including:
(a) a step of obtaining a first result by simulating production of multiple types of the product substrates by the substrate production line on an assumption that provision and collection of the component supply device with respect to the substrate production line are performed without delay;
(b) a step of obtaining a second result by simulating the production of the multiple types of product substrates by the substrate production line on an assumption that provision and/or collection of the component supply device with respect to the substrate production line is performed by an automated facility and/or a worker; and
(c) a step of outputting the first result and the second result on the same screen in a form indicating a transition of a production number of product substrates with respect to time.

In this substrate production simulation method, the first result is a result obtained by simulating the production of multiple types of product substrates by the substrate production line on the assumption that the provision and collection of the component supply device with respect to the substrate production line are performed without delay. The second result is a result obtained by simulating the production of multiple types of product substrates by the substrate production line on the assumption that the provision and/or collection of the component supply device with respect to the substrate production line is performed by the automated facility and/or the worker. The first result and the second result are output on the same screen in the form indicating the transition of the production number of product substrates with respect to time. Therefore, it can be easily confirmed whether the second result is delayed with respect to the first result. In addition, the second result includes the operations of the automated facility and the worker in the premise of the simulation as compared with the first result. Therefore, when a time delay has occurred in the second result with respect to the first result, it can be said that the delay is caused by the automated facility or the worker. Accordingly, according to the substrate production simulation of the present disclosure, it is possible to easily confirm the delay in substrate production caused by the automated facility or the worker.

### Brief Description of Drawings

Fig. 1 is a configuration diagram schematically illustrating substrate production floor F.
Fig. 2 is a perspective view schematically illustrating substrate production line 10.
Fig. 3 is a perspective view schematically illustrating component mounter 20.
Fig. 4 is a block diagram illustrating a configuration related to control of substrate production line 10.
Fig. 5 is a flowchart of a first simulation.
Fig. 6 is a graph illustrating a result of the first simulation.
Fig. 7 is a flowchart of a second simulation.
Fig. 8 is a flowchart of a simulation result display routine.
Fig. 9 is an explanatory diagram illustrating a state in which graphs indicating results of the first and second simulations are displayed on the same screen.
Fig. 10 is an explanatory diagram illustrating another example of substrate production line 10.

### Description of Embodiments

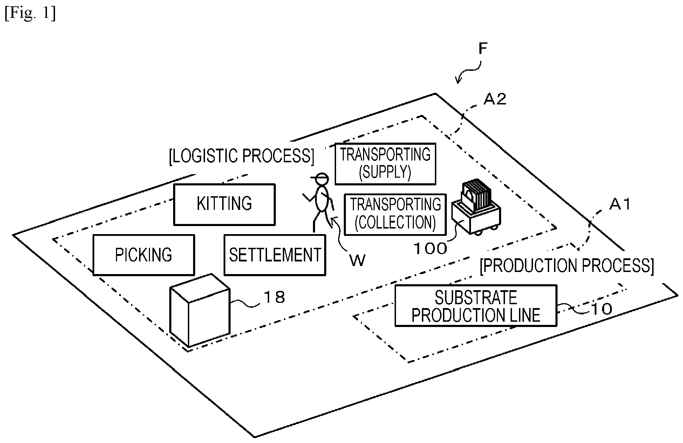

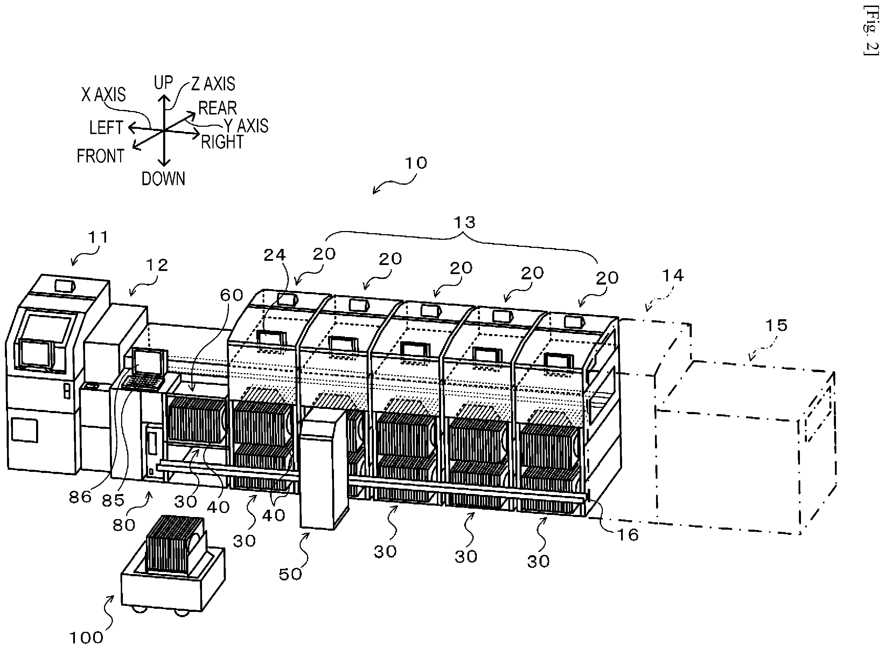

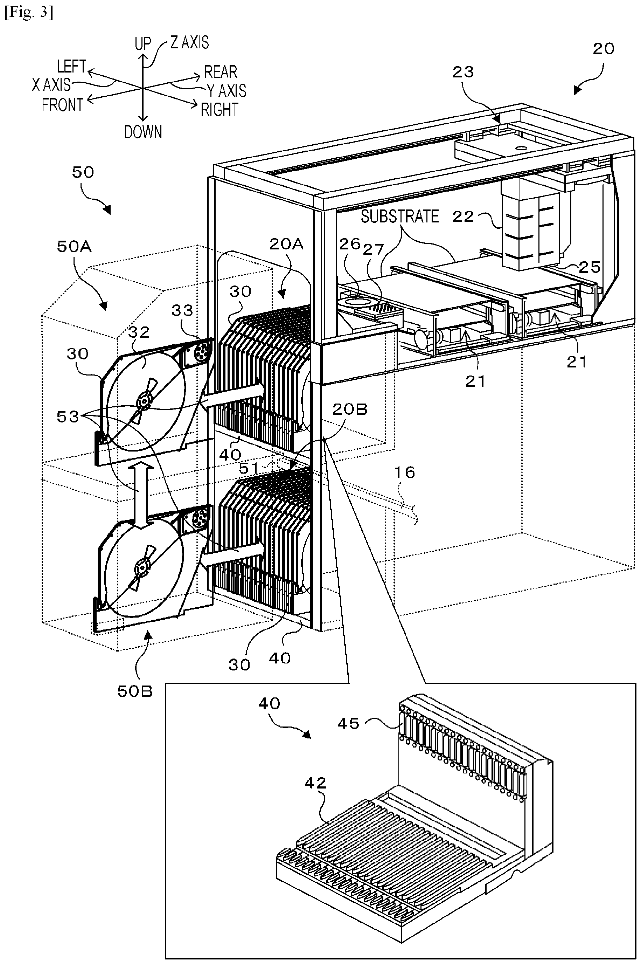

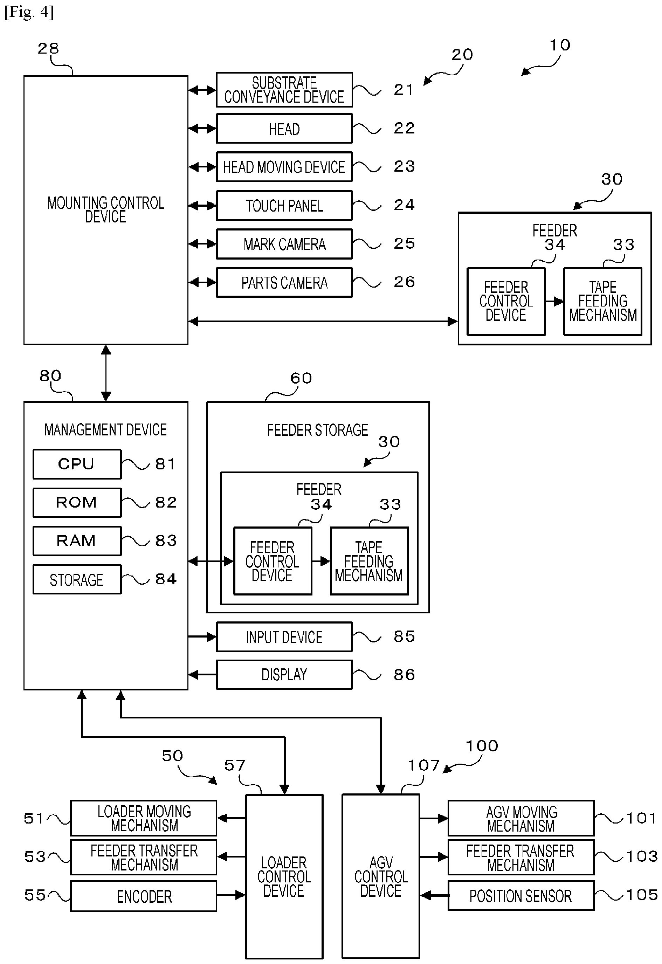

Next, an embodiment of a substrate production simulation method of the present disclosure will be described with reference to the drawings. Fig. 1 is a configuration diagram schematically illustrating substrate production floor F, Fig. 2 is a perspective view schematically illustrating substrate production line 10, Fig. 3 is a perspective view schematically illustrating component mounter 20, and Fig. 4 is a block diagram illustrating a configuration related to control of substrate production line 10. In the present embodiment, a right-left direction (X axis), a front-rear direction (Y axis), and an up-down direction (Z axis) are as illustrated in Figs. 2 and 3.

As illustrated in Fig. 1, substrate production floor F includes first area A1 and second area A2. First area A1 is an area for performing a production process. In first area A1, substrate production line 10 for producing a product (product substrate) obtained by mounting a large number of components on a substrate and soldering a substrate is provided. Second area A2 is an area for performing a logistic process. Component storage warehouse 18, feeder storage location (not illustrated), and the like are disposed in second area A2. Worker W basically performs the logistic process in second area A2.

The production process is a process for producing the product (product substrate) in which a large number of components are mounted and soldered using substrate production line 10.

The logistic process includes picking, kitting, transporting (supplying), transporting (collecting), settlement, and the like. The picking is an operation for taking out a reel for holding components necessary for a production job from component storage warehouse 18. The kitting is an operation of setting the reel in a feeder. The transporting (supplying) is an operation for transporting the kitted feeder from second area A2 to substrate production line 10 of first area A1. The transporting (collecting) is an operation of collecting the feeder used in the production job is finished or the feeder with empty components and transporting the feeders from substrate production line 10 of first area A1 to second area A2. The settlement is an operation which removes the reel with emptied component from the feeder and discards the reel, uses the feeder in which a component that can be used in a later production job remains, or detaches the reel that holds a component that is not used in a later production job from the feeder and returns the reel to component storage warehouse 18. The logistic process may be performed by an automated facility as well as by worker W. Examples of the automated facility include an automatic warehouse and an automated guided vehicle (AGV 100). The automatic warehouse is used as component storage warehouse 18, and automatically delivers necessary components. AGV 100 is a vehicle for automatically transporting a feeder or the like, and travels between first area A1 and second area A2.

As illustrated in Fig. 2, substrate production line 10 includes printing device 11, print inspection device 12, mounting line 13, appearance inspection device 14, reflow furnace 15, feeder storage 60, and management device 80. These constitute substrate production line 10 by aligning them in a conveyance direction (X-direction) of the substrate. Printing device 11 is a device for printing solder on the substrate. Print inspection device 12 is a device for inspecting the state of the solder printed by printing device 11. Mounting line 13 is configured such that multiple component mounters 20 are arranged along a conveyance direction of the substrate. Component mounter 20 is a device that takes out component supplied from feeder 30 and mounts the component on a substrate. Appearance inspection device 14 is a device for inspecting a mounting state of the component mounted by component mounter 20. Reflow furnace 15 melts solder on the substrate by heating the substrate on which a large number of components are mounted, thereby performing solder bonding. The substrate discharged from reflow furnace 15 is a product (product substrate) on which a large number of components are mounted and soldered. Feeder storage 60 is incorporated in substrate production line 10 to store feeder 30 to be used and used feeder 30 in each component mounter 20. Management device 80 manages entire substrate production line 10. Substrate production line 10 also includes loader 50. Loader 50 is movable along X-axis rail 16, so that feeder 30 can be automatically exchanged between component mounter 20 and loader 50 or between feeder storage 60 and loader 50.

As illustrated in Fig. 3, component mounter 20 includes substrate conveyance device 21 that conveys the substrate in the X-direction, head 22 that has a nozzle for picking up the component supplied by feeder 30, head moving mechanism 23 for moving head 22 in the XY directions, and touch panel display 24 (refer to Fig. 2) for performing touch input and screen output. In addition to the above, component mounter 20 includes mark camera 25, parts camera 26, nozzle station 27, and the like. Mark camera 25 images a reference mark attached to a substrate from above in order to detect the position of the substrate. Parts camera 26 images the component picked up by the nozzle provided in head 22 from below in order to detect a pick-up error or a pick-up deviation. Nozzle station 27 accommodates multiple types of nozzles that can be exchanged according to the type of component to be picked up. In addition, component mounter 20 includes mounting control device 28 (refer to Fig. 4) having a well-known CPU, a ROM, a RAM, and the like. Mounting control device 28 controls entire component mounter 20. Mounting control device 28 can input and output a signal to and from substrate conveyance device 21, head 22, head moving mechanism 23, touch panel display 24, mark camera 25, parts camera 26, and the like. In addition, component mounter 20 has two upper and lower areas to which feeders 30 can be attached at a front part thereof. The upper area is supply area 20A to which feeder 30 can supply the component, and the lower area is stock area 20B in which feeder 30 can be stocked. Feeder base 40 formed in an L-shape in a side view, is provided in supply area 20A and stock area 20B. Multiple feeders 30 are attached to each feeder base 40.

Feeder 30 is a kind of component supply device and is configured as a tape feeder for feeding out tapes for accommodating components at a predetermined pitch, as illustrated in Fig. 3. Feeder 30 includes tape reel 32 around which a tape is wound, tape feeding mechanism 33 for feeding out the tape from tape reel 32, and feeder control device 34 (refer to Fig. 4). Feeder base 40 includes multiple slots 42 arranged in the X-direction at an interval into which feeder 30 can be inserted. When feeder 30 is inserted into slot 42 of feeder base 40, a connector (not illustrated) of feeder 30 is connected to connector 45 of feeder base 40. As a result, feeder control device 34 can communicate with the control section (mounting control device 28, management device 80, or the like) of an attachment destination of feeder 30. Feeder control device 34 feeds the component accommodated in the tape to a predetermined component supply position by tape feeding mechanism 33, and when the component at the component supply position is picked up by the nozzle of head 22, feeder control device 34 feeds the component accommodated in the tape to a predetermined component supply position again by tape feeding mechanism 33.

As illustrated in Fig. 2, loader 50 is movable along X-axis rail 16 provided in parallel to the conveyance direction (X-direction) of the substrate on the front faces of multiple component mounters 20 and the front face of feeder storage 60. As illustrated in Figs. 3 and 4, loader 50 includes loader moving mechanism 51 and feeder transfer mechanism 53. Loader moving mechanism 51 moves loader 50 along X-axis rail 16. Feeder transfer mechanism 53 is configured to attach feeder 30 to component mounter 20 or feeder storage 60 from loader 50, detach feeder 30 from component mounter 20 or feeder storage 60 to accommodate feeder 30 in loader 50, and move feeder 30 between upper transfer area 50A and lower transfer area 50B. As illustrated in Fig. 4, loader 50 also includes encoder 55 and loader control device 57. Encoder 55 detects a movement position of loader 50 in the X-direction. Loader control device 57 includes a well-known CPU, a ROM, a RAM, and the like. Loader control device 57 inputs a detection signal from encoder 55 and outputs a drive signal to loader moving mechanism 51 and feeder transfer mechanism 53.

Feeder storage 60 has feeder base 40 having the same configuration as that of feeder base 40 provided in component mounter 20 in order to accommodate multiple feeders 30.

AGV 100 is one of the automated facilities responsible for logistic processes (particularly transporting). AGV 100 replenishes feeder 30 on which the components necessary for production are mounted in feeder storage 60 or collects used feeder 30 from feeder storage 60 while moving between feeder storage 60 of first area A1 and component storage warehouse 18 of second area A2. As illustrated in Fig. 4, AGV 100 includes AGV moving mechanism 101 and feeder transfer mechanism 103. AGV moving mechanism 101 is for traveling AGV 100 along a predetermined traveling route, and includes a motor for traveling and a steering device. Feeder transfer mechanism 103 is a device similar to feeder transfer mechanism 53 of above-described loader 50, and can automatically exchange feeder 30 between feeder storage 60 and feeder transfer mechanism 103 or between component storage warehouse 18 and feeder transfer mechanism 103. As illustrated in Fig. 4, AGV 100 also includes position sensor 105 and AGV control device 107. Position sensor 105 detects a traveling position of AGV 100. AGV control device 107 includes a well-known CPU, a ROM, a RAM, and the like. AGV control device 107 inputs a detection signal from position sensor 105, and outputs a drive signal to AGV moving mechanism 101 or feeder transfer mechanism 103.

As illustrated in Fig. 4, management device 80 includes well-known CPU 81, ROM 82, RAM 83, a storage (HDD or SSD) 84, and the like, and is connected to input device 85 such as a keyboard or a mouse, or display 86 such as an LCD. Management device 80 is connected to mounting control device 28, loader control device 57, and AGV control device 107 so as to be capable of bidirectional communication. Management device 80 receives information on a mounting status of component mounter 20 from mounting control device 28, receives information on a driving status of loader 50 from loader control device 57, and receives information on a driving status of AGV 100 from AGV control device 107. Management device 80 transmits a command signal relating to the mounting to mounting control device 28, transmits a command signal relating to loader 50 to loader control device 57, and transmits a command signal relating to AGV 100 to AGV control device 107. Management device 80 is communicably connected to feeder control device 34 of feeder 30 stored in feeder storage 60, so that information of stored feeder 30 can be acquired. Management device 80 stores the production plan in storage 84. The production plan includes production information, a production target, and the like. The production information includes information on a component necessary for manufacturing a product substrate, information on a target number of products for manufacturing a product substrate, and the like. The production plan includes a plan to produce multiple types of product substrates. Therefore, the production information is stored for each type of the product substrate. The production target includes a target production time required for executing the production plan or the like.

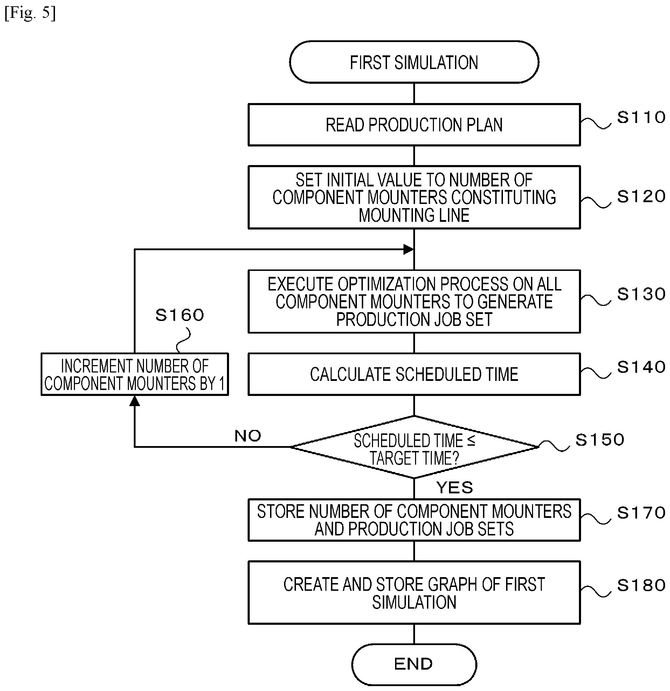

Next, a first simulation performed by management device 80 will be described. The first simulation is a simulation executed on the assumption that the provision and collection of feeder 30 with respect to mounting line 13 are performed without delay. Fig. 5 is a flowchart of the first simulation. In the first simulation, when various product substrates are continuously produced, a production job to be applied to each component mounter 20 is optimized so that the production efficiency in mounting line 13 is as high as possible, and the number of component mounters 20 constituting mounting line 13 is set so as to meet the production target. The production job is a job in which, for each component mounter 20, which feeder 30 is set in feeder base 40 in what order, and which component type of component is mounted on substrate S in what order, and the like are determined.

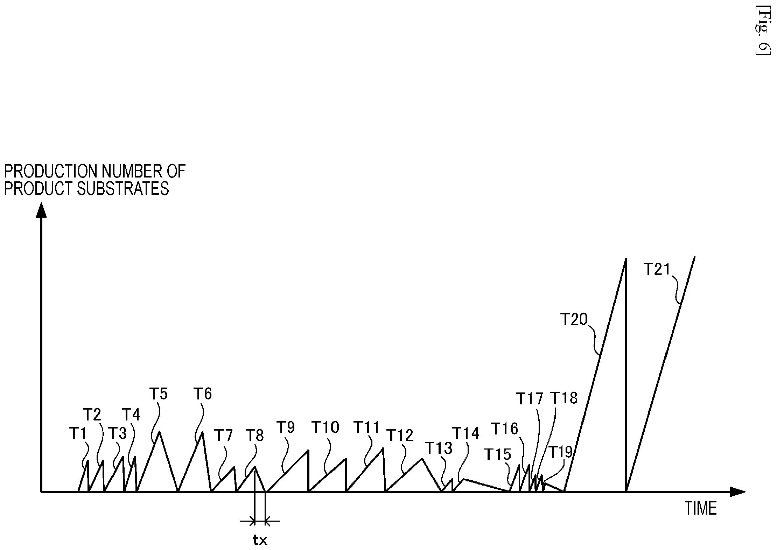

When the first simulation is started, CPU 81 of management device 80 reads the current production plan from storage 84 (S110). Next, CPU 81 sets a predetermined initial value (for example, 4) to the number of component mounters constituting mounting line 13 (S120). Next, CPU 81 executes an optimization process on all component mounters 20 constituting mounting line 13 to generate a production job set (including production jobs of all component mounters 20) (S130). In this case, it is assumed that various product substrates are subsequently manufactured by each target number of substrates. Therefore, the production job set is generated for each type of the product substrate. Next, CPU 81 calculates a scheduled production time required to execute the current production plan (S140). In calculating the scheduled production time, CPU 81 calculates the scheduled production time in consideration of the operation time of loader 50 if the exchange operation of feeder 30 by loader 50 is necessary when the manufacturing of the next type of product substrate starts after the target number of product substrates having a certain type is manufactured. Next, CPU 81 determines whether the scheduled production time is within the target production time (S150), and when the scheduled time exceeds the target production time, the number of component mounters 20 constituting mounting line 13 is incremented by 1 (S160), and the process returns to S130 again. Meanwhile, when the scheduled production time is within the target production time in S150, CPU 81 stores the number of component mounters 20 at that time and the optimized production job set in storage 84 (S170). Thereafter, CPU 81 creates a graph (refer to Fig. 6) indicating the transition of the production number of product substrates with respect to time based on the result obtained in S170, stores the graph in storage 84 (S180), and finishes the simulation.

Here, an optimization process of the production job set in a case where a certain type of product substrate is manufactured will be described. CPU 81 finds a production job set in which a scheduled processing time (scheduled cycle time) of the production job in each component mounter 20 falls within a predetermined allowable range and a production time in mounting line 13 is minimized. In generating the production job, CPU 81 sets a mounting sequence based on the production plan, allocates the mounting sequence to each component mounter 20, sets a mounting order of the components allocated for each component mounter 20, sets an arrangement method of feeders 30 for each component mounter 20, and generates production jobs of all component mounters 20. The mounting sequence is set by designating a component type, a mounting position, and a type of nozzle to be used (type of use nozzle) in the mounting order. The allocation of the mounting sequence to each component mounter 20 is performed so that the number of the mounting sequences allocated to each component mounter 20 is equal or as uniform as possible. The mounting order of the components is set so that the mounting of the component is not obstructed by the component previously mounted, for example, when the component is mounted substrate S. The arrangement method of feeders 30 is set such that feeder 30 supplying the component having a large number of being mounted on substrate S in each component mounter 20 is closer to the center of feeder base 40, for example. Since there are multiple mounting sequences, allocation of mounting sequences, mounting order of the allocated components, and arrangement methods of feeders 30, respectively, the combination of the production job sets becomes an enormous number. When calculating the scheduled cycle time of each component mounter 20, CPU 81 calculates the scheduled cycle time based on simulation or data stored in the past. CPU 81 finds out a production job set in which the scheduled cycle time of all component mounters 20 falls within a predetermined allowable range and the production time is minimized from among combinations of an enormous number of production job sets.

Fig. 6 is a graph illustrating the results of the first simulation, and is a graph illustrating the transition of the production number of product substrates with respect to the time in the case of manufacturing various product substrates. In Fig. 6, it is assumed that there are 21 types of product substrates such as types T1 to T21. In this graph, a large number of line segments rising to the right are present, but each line segment represents a process for producing a target number of product substrates of one type. For example, the process until a target number of product substrates of type T1 is produced is represented by the leftmost line segment rising to the right in Fig. 6. When the process is finished, the number of substrates is once reset to zero. Thereafter, the process until a target number of product substrates of type T2 is produced is represented by the second line segment rising to the right from the left in Fig. 6. In addition, although a section from the time when the target number of product substrates of type T5 is produced to the time when the product substrate of type T6 starts to be produced is a line segment that slopes downward to the right, the exchange operation of feeder 30 by loader 50 of substrate production line 10 is performed in this section.

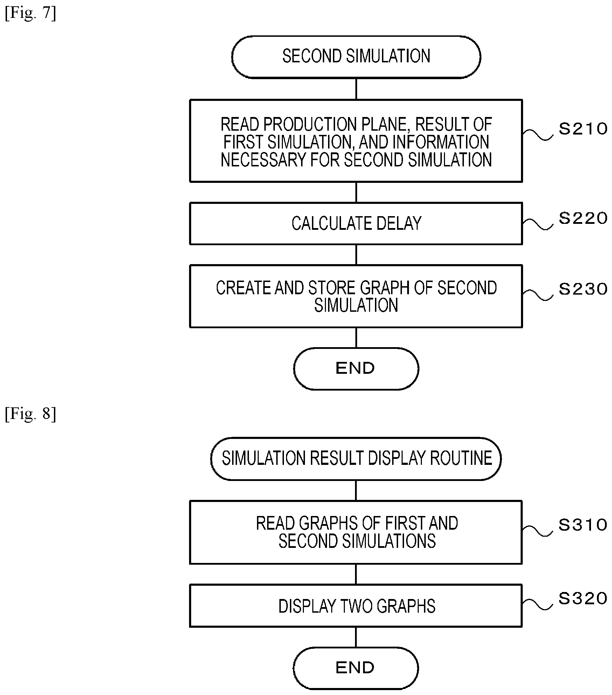

Next, a second simulation performed by management device 80 will be described. Fig. 7 is a flowchart of the second simulation. The second simulation is a simulation executed on the assumption that the provision and collection of feeder 30 with respect to mounting line 13 are performed by an automated facility (such as AGV 100 or the automatic warehouse) or worker W, and is executed after the above-described first simulation is finished. The second simulation is achieved by, for example, Plant Simulation manufactured by Siemens Corporation.

Before the second simulation is started, the operator inputs information necessary for the second simulation using input device 85. Examples of the information necessary for the second simulation include the number of workers W in charge of the logistic process, the type and the number of automated facilities, the operation time required for picking, the operation time required for kitting, the time required for transporting, the operation time required for the post-process, or the like. Examples of the operation time required for picking include a time to take out the component from component storage warehouse 18, a time to move the component from a picking operation location to a kitting operation location, and the like. Examples of the operation time required for the kitting include a time to take out feeder 30 from the feeder storage location, a time to attach tape reel 32 to feeder 30, and the like. Examples of the time required for transporting include a transporting time to supply feeder 30 of second area A2 to substrate production line 10 of first area A1, a transporting time to collect feeder 30 from substrate production line 10 of first area A1 and moving feeder 30 to second area A2, and the like. Such a transporting time can be calculated from a movement speed and a movement distance of worker W when worker W performs the transporting, and can be calculated from a movement speed and a movement distance of AGV 100 when AGV 100 performs the transporting. Examples of the time required for the post-process include a time to detach tape reel 32 from feeder 30, a time to return feeder 30 to the feeder storage location, and the like. The information inputted by the operator is stored in storage 84.

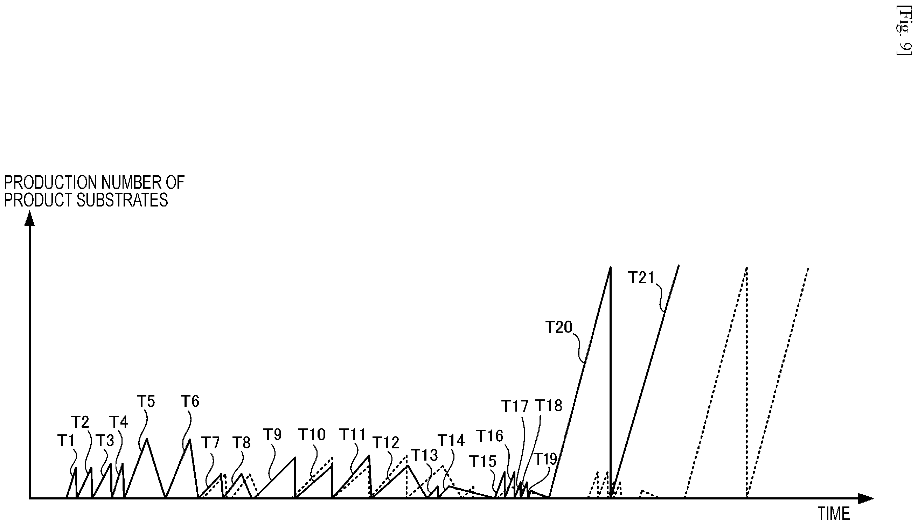

When the second simulation is started, CPU 81 of management device 80 reads the current production plan, the result (the number and the production job set) obtained in the first simulation, and the information necessary for the second simulation from storage 84 (S210). Next, CPU 81 calculates a delay caused by the provision and collection of feeder 30 with respect to mounting line 13 being performed by the automated facility or worker W (S220). The delay is calculated based on the information read in S210. For example, in the graph of Fig. 6 obtained by the first simulation, the time from the end of the production of the product substrate of type T8 to the start of the production of the product substrate of type T9 is tx. However, in a case where the number of feeders 30 to be exchanged is large on mounting line 13, depending on the number of workers W and the number of the automated facilities, the picking and kitting operations in the logistic process may not be finished even after the time tx has passed since the production of the product substrate of type T8 is finished. In S220, such a delay is calculated. Next, CPU 81 creates a graph indicating the result of the second simulation, stores the graph in storage 84 (S230), and finishes the present simulation. Specifically, CPU 81 creates a graph taking into consideration the delay calculated in S220 based on the graph obtained in S180 of the first simulation (refer to the graph with dashed lines in Fig. 9).

Next, a simulation result display routine executed by management device 80 will be described. Fig. 8 is a flowchart of this routine. This routine is executed after the end of the above-described second simulation. When this routine is started, CPU 81 of management device 80 reads the graphs of the first and second simulations from storage 84 (S310). Next, CPU 81 displays the two graphs on the same screen of display 86 (S320), and finishes the present routine. In S320, as illustrated in Fig. 9, the two graphs are output as a graph in which a production start time is matched on a coordinate having a horizontal axis of time and a vertical axis of the production number of the product substrates. In Fig. 9, solid lines represent results obtained in the first simulation, and dashed lines represent results obtained in the second simulation. According to Fig. 9, it is obvious at first glance that the dashed line is delayed as compared with the solid line. As a result, since the number of the inputted workers W or the type and the number of the automated facilities were not appropriate, a delay occurred in the logistic process, and it can be seen that the production process could not be produced in an ideal manner. In such a case, the operator performs the second simulation again by changing the number of workers W and the type and number of automated facilities. This operation is repeated until the two graphs outputted on the same screen coincide with each other (or until the deviation of the two graphs falls within the allowable range).

Here, a correspondence between the component of the present embodiment and the component of the substrate production simulation method of the present disclosure will be clarified. The first simulation of the present embodiment corresponds to the step (a) of the present disclosure, the second simulation corresponds to the step (b), and the simulation result display routine corresponds to the step (c).

In the present embodiment described above, the result of the first simulation is a result of simulation on the assumption that the provision and collection of feeder 30 with respect to substrate production line 10 are performed without delay. The result of the second simulation is a result obtained by performing simulation on the assumption that the provision and/or collection of feeder 30 with respect to substrate production line 10 is performed by the automated facility and/or worker W. The first result and the second result are output on the same screen in the form indicating the transition of the production number of product substrates with respect to time. Therefore, it can be easily confirmed whether the second result is delayed with respect to the first result. In addition, the second result includes the operations of the automated facility and worker W in the premise of the simulation as compared with the first result. Therefore, when a time delay has occurred in the second result with respect to the first result, it can be said that the delay is caused by the automated facility or worker W (caused by the logistic process). Accordingly, according to the present embodiment, it is possible to easily confirm the delay in the production of the product substrate caused by the automated facility or worker W.

In addition, the results of the first and second simulations are output as a graph in which the production start time is matched on a coordinate having a horizontal axis of time and a vertical axis of the production number of the product substrates (refer to Fig. 9). Therefore, it is possible to more easily confirm whether a delay in the production of the product substrate has occurred than in a case where the transition of the production number of the product substrates with respect to time is output in a tabular format.

Further, when the result of the second simulation is delayed with respect to the result of the first simulation, the number of the automated facilities and/or the number of workers W are changed so that the delay is canceled, and the operation of executing the second simulation again using the changed number and outputting the results of both simulations to the same screen is repeated until the delay of the result of the second simulation with respect to the result of the first simulation falls within the allowable range. Therefore, it is possible to know the number of automated facilities and/or the number of workers W in which a delay in production of the product substrate does not occur.

Further, the provision and/or collection of feeder 30 includes the operation for taking out the component necessary for substrate production from the warehouse, the operation for setting tape reel 32 in feeder 30 used in component mounter 20, the operation for transporting feeder 30 in which the component is set to substrate production line 10, and the operation for collecting feeder 30 which becomes unnecessary from substrate production line 10. These operations tend to cause the delay in the production of the product substrate.

It is needless to say that the present invention is not limited to the above-described embodiments, and may be practiced in various forms as long as it belongs to the technical scope of the present invention.

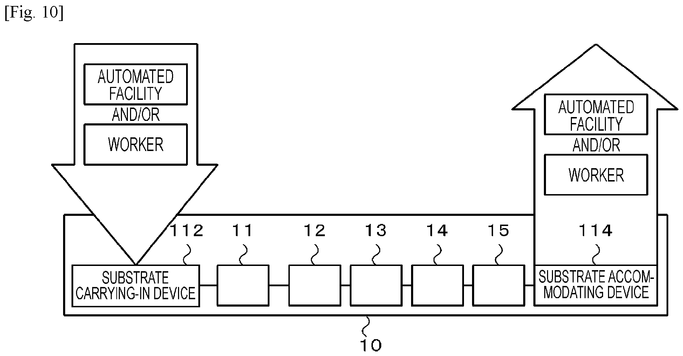

For example, as illustrated in Fig. 10, substrate production line 10 of the above-described embodiment may include substrate supplying device 112 that supplies an unmounted substrate on which the component is not mounted to printing device 11 located upstream of mounting line 13, and substrate accommodating device 114 that accommodates the product substrate from reflow furnace 15 located downstream of mounting line 13. In the first simulation, simulation may be performed on the assumption that a mounting operation for mounting the unmounted substrate on substrate supplying device 112 and a taking-out operation for taking out the product substrate from substrate accommodating device 114 without delay, and in the second simulation, simulation may be performed on the assumption that the mounting operation and the taking-out operation is performed by the automated facility (for example, AGV 100) and/or worker W. The mounting operation and the taking-out operation are logistic processes. As a result, it is possible to easily confirm the delay in substrate production caused by the automated facility or worker W in substrate production line 10 including substrate supplying device 112 and substrate accommodating device 114. Specifically, it is possible to estimate a stagnation status of production due to a delay in preparation for carrying-in the unmounted substrate or a delay in accommodation of the product substrate.

In the above-described embodiment, substrate production line 10 includes printing device 11. In this case, in the first simulation, the simulation may be performed on the assumption that the preparation operation of printing device 11 (for example, supply operation of solder paste to printing device 11, exchange operation of mask and squeegee, or the like) is performed without delay, and in the second simulation, the simulation may be performed on the assumption that the preparation operation of printing device 11 is performed by the automated facility (for example, an AGV) or worker W. The preparation operation of printing device 11 is the logistic process. In this way, it is possible to easily confirm, in substrate production line 10 including printing device 11, the delay in the substrate production caused by the automated facility or worker W.

In the above-described embodiment, the results of the first and second simulations are output as a graph in which the production start time is matched on a coordinate having a horizontal axis of time and a vertical axis of the production number of product substrate, but graphs representing the results may be output by arranging the graphs vertically or horizontally on the screen. In addition, the results of the first and second simulations may be output in a tabular format in which the production number of product substrates is associated with each other in time.

In the above-described embodiment, management device 80 executes the first and second simulations, but the present invention is not particularly limited to this. For example, one computer or multiple computers other than management device 80 may execute the first and second simulations.

In the above-described embodiment, feeder 30 is exemplified as the component supply device, but a tray on which components are placed may be used instead of or together with feeder 30.

In the above-described embodiment, CPU 81 may determine whether the deviation of the two graphs obtained in S320 of the simulation result display routine is within the allowable range, and when the deviation is not satisfied, automatically increase at least one of the number of workers W and the type and number of the automated facilities, and execute the second simulation again, and repeat the operation until the deviation of the two graphs falls within the allowable range.

The substrate production simulation method of the present disclosure may be configured as follows.

In the substrate production simulation method of the present disclosure, in the step (c), the first result and the second result may be output as a graph in which a production start time is matched on a coordinate having a horizontal axis of time and a vertical axis of the production number of the product substrates. In this way, it is possible to more easily confirm whether a delay in substrate production has occurred than a case where the transition of the production number of product substrates with respect to time is output in a tabular format.

The substrate production simulation method of the present disclosure may further include (d) a step of changing, when the second result is delayed with respect to the first result in the step (c), the number of the automated facilities and/or the number of the workers so that the delay of the second result is canceled and executing the step (b) and step (c) again using the changed number, and (e) a step of repeating the step (d) until the delay of the second result with respect to the first result falls within an allowable range in the step (c). In this way, it is possible to know the number of automated facilities and/or the number of workers in which a delay in substrate production does not occur.

In the substrate production simulation method of the present disclosure, the provision and/or collection of the component supply device may include at least one of an operation for taking out the component necessary for the substrate production from a warehouse, an operation for setting the component in the component supply device used in the component mounter, an operation for transporting the component supply device in which the component is set to the substrate production line, and an operation for collecting the component supply device which becomes unnecessary from the substrate production line.

In the substrate production simulation method of the present disclosure, the substrate production line may include a substrate supplying device for supplying an unmounted substrate on which the component is not mounted to an upstream side of the mounting line and/or a substrate accommodating device for accommodating the substrate on which the mounting of the component is completed from a downstream side of the mounting line, in the step (a), simulation may be performed on an assumption that a mounting operation for mounting the unmounted substrate on the substrate supplying device and/or a taking-out operation for taking out the product substrate from the substrate accommodating device is performed without delay, and in the step (b), simulation may be performed on an assumption that the mounting operation and/or the taking-out operation is performed by the automated facility and/or the worker. In this way, it is possible to easily confirm a delay in substrate production caused by the automated facility or the worker in the substrate production line including the substrate supplying device or the substrate accommodating device.

In the substrate production simulation method of the present disclosure, the substrate production line may include a printing device for printing a solder paste on the substrate on an upstream side of the mounting line, in the step (a), simulation may be performed on an assumption that a preparation operation of the printing device is performed without delay, and in the step (b), simulation may be performed on an assumption that the preparation operation of the printing device is performed by the automated facility and/or the worker. In this way, in a substrate production line including the printing device, it is possible to easily confirm a delay in substrate production caused by the automated facility or the worker.

### Industrial Applicability

The substrate production simulation method of the present disclosure can be used when producing a product substrate in which mounting of a component is completed using a substrate production line.

### Reference Signs List

10: substrate production line, 11: printing device, 12: print inspection device, 13: mounting line, 14: appearance inspection device, 15: reflow furnace, 16: X-axis rail, 18: component storage warehouse, 20: component mounter, 20A: supply area, 20B: stock area, 21: substrate conveyance device, 22: head, 23: head moving mechanism, 24: touch panel display, 25: mark camera, 26: parts camera, 27: nozzle station, 28: mounting control device, 30: feeder, 32: tape reel, 33: tape feeding mechanism, 34: feeder control device, 40: feeder base, 42: slot, 45: connector, 50: loader, 50A: upper transfer area, 50B: lower transfer area, 51: loader moving mechanism, 53: feeder transfer mechanism, 55: encoder, 57: loader control device, 60: feeder storage, 80: management device, 81: CPU, 82: ROM, 83: RAM, 84: storage, 85: input device, 86: display, 100: AGV, 101: AGV moving mechanism, 103: feeder transfer mechanism, 105: position sensor, 107: AGV control device, 112: substrate supplying device, 114: substrate accommodating device, A1: first area, A2: second area, F: substrate production floor, and W: worker

## Claims

1. A substrate production simulation method of simulating production of a product substrate on which mounting of a component supplied from a component supply device is completed using a substrate production line including a mounting line in which multiple component mounters for mounting the component on a substrate are arranged along a conveyance direction of the substrate, the substrate production simulation method comprising:
(a) a step of obtaining a first result by simulating production of multiple types of the product substrates by the substrate production line on an assumption that provision and collection of the component supply device with respect to the substrate production line are performed without delay;
(b) a step of obtaining a second result by simulating the production of the multiple types of product substrates by the substrate production line on an assumption that provision and/or collection of the component supply device with respect to the substrate production line is performed by an automated facility and/or a worker; and
(c) a step of outputting the first result and the second result on the same screen in a form indicating a transition of a production number of product substrates with respect to time.

2. The substrate production simulation method according to claim 1,
wherein in the step (c), the first result and the second result are output as a graph in which a production start time is matched on a coordinate having a horizontal axis of time and a vertical axis of the production number of the product substrates.

3. The substrate production simulation method according to claim 1 or 2, further comprising:
(d) a step of changing, when the second result is delayed with respect to the first result in the step (c), the number of the automated facilities and/or the number of the workers so that the delay of the second result is canceled and executing the step (b) and step (c) again using the changed number; and
(e) a step of repeating the step (d) until the delay of the second result with respect to the first result falls within an allowable range in the step (c).

4. The substrate production simulation method according to any one of claims 1 to 3,
wherein the provision and/or collection of the component supply device includes at least one of an operation for taking out the component necessary for the substrate production from a warehouse, an operation for setting the component in the component supply device used in the component mounter, an operation for transporting the component supply device in which the component is set to the substrate production line, and an operation for collecting the component supply device which becomes unnecessary from the substrate production line.

5. The substrate production simulation method according to any one of claims 1 to 4,
wherein the substrate production line includes a substrate supplying device for supplying an unmounted substrate on which the component is not mounted to an upstream side of the mounting line and/or a substrate accommodating device for accommodating the substrate on which the mounting of the component is completed from a downstream side of the mounting line,
in the step (a), simulation is performed on an assumption that a mounting operation for mounting the unmounted substrate on the substrate supplying device and/or a taking-out operation for taking out the product substrate from the substrate accommodating device is performed without delay, and
in the step (b), simulation is performed on an assumption that the mounting operation and/or the taking-out operation is performed by the automated facility and/or the worker.

6. The substrate production simulation method according to any one of claims 1 to 5,
wherein the substrate production line includes a printing device for printing a solder paste on the substrate on an upstream side of the mounting line,
in the step (a), simulation is performed on an assumption that a preparation operation of the printing device is performed without delay, and
in the step (b), simulation is performed on an assumption that the preparation operation of the printing device is performed by the automated facility and/or the worker.
